# EUROPÄISCHE PATENTSCHRIFT

(11) **EP 2 315 792 B1**
(45) Veröffentlichungstag und Bekanntmachung des Hinweises auf die Patenterteilung: **17.02.2016**
(21) Anmeldenummer: 09777642.1
(22) Anmeldetag: 04.08.2009
(51) Int. Cl.: C08G 2/06, C08G 61/12, C09K 11/06, H01L 51/00, H01L 51/50

(54) **ELEKTROLUMINESZIERENDE POLYMERE, VERFAHREN ZU IHRER HERSTELLUNG SOWIE IHRE VERWENDUNG**
ELECTROLUMINESCENT POLYMERS, METHOD FOR THE PRODUCTION THEREOF, AND USE THEREOF
POLYMÈRES ÉLECTROLUMINESCENTS, LEUR PROCÉDÉ DE PRODUCTION ET LEUR UTILISATION

(30) Priorität: 29.08.2008 DE 102008044868
(43) Veröffentlichungstag der Anmeldung: 04.05.2011
(73) Patentinhaber: Merck Patent GmbH, 64293 Darmstadt (DE)
(72) Erfinder: HEUN, Susanne, 65812 Bad Soden (DE); LUDEMANN, Aurélie, 60322 Frankfurt (DE); ANEMIAN, Rémi, Manouk, 60316 Frankfurt (DE); SCHULTE, Niels, 65779 Kelkheim (DE)
(86) Internationale Anmeldenummer: PCT/EP2009/005639
(87) Internationale Veröffentlichungsnummer: WO 2010/022847

(56) Entgegenhaltungen:
- WO-A-02/077060
- WO-A-03/016430
- WO-A-2008/011953
- CUIHUA XUE: "Novel p-phenylene-vinylene-dithienylene type copolymer" SYNTHETIC METALS, Bd. 145, 2. Juni 2006 (2006-06-02), Seiten 67-73, XP002550735 Amsterdam
- PAWEL WAGNER: "Synthesis and characterization of novel styryl-substituted oligothienylenevinylenes" TETRAHEDRON, Bd. 62, 10. Januar 2006 (2006-01-10), Seiten 2190-2199, XP002550736 Amsterdam
- HWANG D-H ET AL: "Band gap tuning of new light emitting conjugated polymers" OPTICAL MATERIALS, ELSEVIER SCIENCE PUBLISHERS B.V. AMSTERDAM, NL, Bd. 21, Nr. 1-3, 1. Januar 2003 (2003-01-01), Seiten 199-203, XP004395421 ISSN: 0925-3467
- YASUTOSHI WATANABE: "Synthesis and Physical Properties of Side-Chain Type Liquid Crystalline Poly(arylenevinylene)s" MACROMOLECULES, Bd. 30, 1997, Seiten 1857-1859, XP002550737 usa

## Beschreibung

Die vorliegende Erfindung betrifft elektrolumineszierende Polymere, die 0,01 bis 50 mol% einer oder mehrerer Struktureinheiten der Formel (I) und/oder (II) enthalten, Verbindungen der Formel (III) und (IV), Mischungen (Blends) und Formulierungen enthaltend diese Polymere sowie die Verwendung dieser Polymere in elektronischen Vorrichtungen, insbesondere in organischen Leuchtdioden, sogenannten OLEDs (OLED = Organic Light Emitting Diode). Die erfindungsgemäßen Polymere zeigen eine verbesserte Effizienz und eine höhere Lebensdauer, insbesondere bei Verwendung in OLEDs.

Konjugierte Polymere werden bereits seit langem intensiv als vielversprechende Materialien in OLEDs untersucht. OLEDs, die als organische Materialien Polymere aufweisen, werden dabei häufig auch als PLEDs (PLED = Polymer Light Emitting Diode) bezeichnet. Ihre einfache Herstellung verspricht eine kostengünstige Herstellung von entsprechenden Leuchtdioden.

Da PLEDs meist nur aus einer lichtemittierenden Schicht bestehen, werden Polymere benötigt, die möglichst sämtliche Funktionen (Ladungsinjektion, Ladungstransport, Rekombination) einer OLED in sich vereinigen können. Um diese Anforderungen zu erfüllen, werden während der Polymerisation unterschiedliche Monomere eingesetzt, die die entsprechenden Funktionen übernehmen. So ist es für die Erzeugung aller drei Emissionsfarben in der Regel nötig, bestimmte Comonomere in die entsprechenden Polymere einzupolymerisieren (vgl. z.B.
WO 00/46321 A1, WO 03/020790 A2 und WO 02/077060 A1). So ist beispielsweise ausgehend von einem blau emittierenden Grundpolymer ("backbone") die Erzeugung der beiden anderen Primärfarben Rot und Grün möglich.

Als Polymere für vollfarbige Anzeigeelemente (Full-Colour-Displays) wurden bereits verschiedene Materialklassen, wie zum Beispiel Polypara-Phenylene (PPP), vorgeschlagen bzw. entwickelt. So kommen zum Beispiel Poly-Fluoren-, Poly-Spirobifluoren-, Poly-Phenanthren-, Poly-Dihydrophenanthren- und Poly-Indenofluoren-Derivate in Betracht. Auch Polymere, die eine Kombination der genannten Strukturelemente enthalten, wurden bereits vorgeschlagen.

Die wichtigsten Kriterien einer OLED sind Effizienz, Farbe und Lebensdauer. Da diese Eigenschaften maßgeblich durch den/die verwendeten Emitter bestimmt werden, werden Verbesserungen der Emitter gegenüber den aus dem Stand der Technik bekannten Materialien weiterhin benötigt.

Insbesondere ist die Lebensdauer der grün und vor allem der blau emittierenden Polymere für viele Anwendungen noch nicht optimal. Gleiches gilt für die Effizienz der rot emittierenden Polymeren.

In der WO 2005/030827 A1 werden Polymere offenbart, die weißes Licht emittieren. Als grün emittierende Comonomere werden dabei unter anderem Vinylaryleneinheiten der folgenden allgemeinen Formel 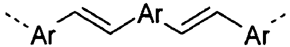 vorgeschlagen, worin Ar ein optional substituiertes, aromatisches oder heteroaromatisches Ringsystem ist. Dabei sollen diese Einheiten mindestens ein elektronenreiches oder elektronenreiche Substituenten aufweisendes Ringsystem Ar enthalten, wie z.B. Thiophen, Furan, Pyrrol oder mit Alkoxy-, Aryloxy- oder Aminogruppen substituiertes Phenyl. Die konkreten Beispiele der WO 2005/030827 A1 offenbaren ein Monomer der folgenden Formel 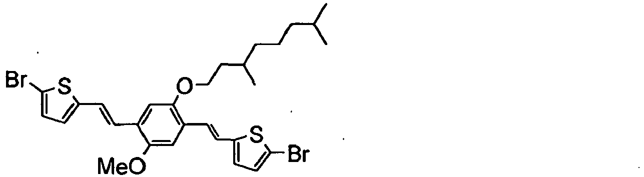 mit zwei Thiophen-2,5-diylgruppen und einer 1,4-Dialkoxy-phenylgruppe. C. Xue, et al. beschreibt in Synthetic Metals 2014, 145, S. 67-73 p-Phenyl-vinylen-dithienylen Copolymerisate als potentielle rotemittierende Materialien, die eine substitutierte 2,5-Bis[(1E)-2-(2-thienyl)vinyl]-benzol-Struktureinheit aufweisen.

In der WO 2008/011953 werden Polymermischungen offenbart, die ein oder mehrere Lochtransportpolymere und ein oder mehrere Elektrontransportpolymere umfassen. Die Polymermischungen umfassen ein erstes Polymer mit einer Einheit mit lochtransportierender Eigenschaft, ein zweites Polymer mit einer Einheit mit elektronentransportierender Eigenschaft und einer Einheit mit Excitonen-bildender Eigenschaft und wahlweise einer oder mehrerer weiterer Einheiten mit emittierender Eigenschaft und/oder Excitonen-bildender Eigenschaft, wobei jede der Einheiten durch ein bestimmtes HOMO und LUMO gekennzeichnet ist. Die konkreten Beispiele der WO 2008/011953 offenbaren ein Copolymer, das die folgenden Monomere enthält:

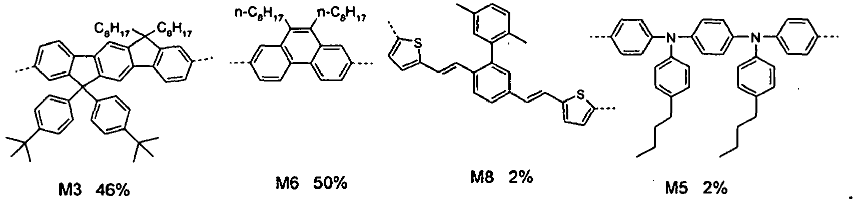

Mit Vinylarylenverbindungen aus dem Stand der Technik können in Bezug auf kürzere Wellenlängen nur grüne Emittereinheiten erhalten werden, die zusätzlich bei Verwendung von höheren Konzentrationen im Polymer eine Verschiebung der Emissionsfarbe zu Gelb zeigen. Andere Farben, vor allem blau, sind mit den aus dem Stand der Technik bekannten Emittern nicht zu realisieren. Außerdem zeigen die Emitter aus dem Stand der Technik eine erhöhte Oxidationsempfindlichkeit in Lösung und sind daher schwer aufzureinigen.

Eine der Aufgaben der vorliegenden Erfindung war daher die Bereitstellung von elektrolumineszierenden Polymeren, welche eine verbesserte Effizienz und eine höhere Lebensdauer aufweisen und vor allem auch blaue Emissionsfarbe im Polymer ermöglichen. Diese Aufgabe wird erfindungsgemäß gelöst durch die Bereitstellung von elektrolumineszierenden Polymeren, die 0,01 bis 50 mol% einer oder mehrerer Struktureinheiten der Formel (I) und/oder (II) gemäß Anspruch 1 enthalten.

Überraschenderweise wurde gefunden, dass die elektrolumineszierenden Polymere enthaltend Struktureinheiten der Formel (I) und/oder (II) gemäß Anspruch 1, sehr gute Eigenschaften aufweisen. Insbesondere zeigen sie sehr hohe Effizienzen und erhöhen die Lebensdauern um mehrere Größenordnung-en im Vergleich zu bisherigen Referenz-Systemen. Die neuen Strukturein-heiten eignen sich insbesondere als Emitter, aber je nach Substitutions-muster auch als Polymer-Grundgerüst, Lochleiter oder Elektronenleiter.

Gegenstand der vorliegenden Erfindung sind somit Polymere enthaltend 0,01 bis 50 mol% einer oder mehrerer Struktureinheiten der Formel (I) und/oder (II) 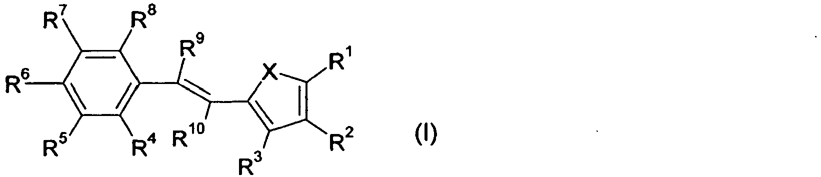 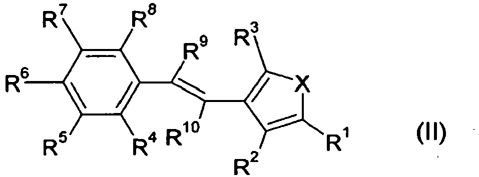 wobei die verwendeten Symbole und Indices die folgenden Bedeutungen besitzen:
- R², R³, R⁴, R⁵, R⁷, R⁸, R⁹ und R¹⁰: sind unabhängig voneinander, gleich oder verschieden, H, Halogen (F, Cl, Br, I), -NO₂, -NCS, -NCO, -OCN, -SCN,
-SF₅, -Si(R)₃ oder eine geradkettige, verzweigte oder cyclische Alkyl- oder Alkoxygruppe mit 1 bis 22 C-Atomen, in der auch ein oder mehrere nicht benachbarte C-Atome durch -C(R)=C(R)-, -C≡C-, -N(R)-, -O-, -S-, -CO-, -CO-O-, -O-CO- oder -O-CO-O- ersetzt sein können, wobei auch ein oder mehrere H-Atome durch Fluor ersetzt sein können,
- R: ist bei jedem Auftreten, gleich oder verschieden H, Halogen, eine geradkettige, verzweigte oder cyclische Alkylkette mit 1 bis 22 C-Atomen, in der auch ein oder mehrere nicht benachbarte C-Atome durch -O-, -S-, -CO-, -CO-Ö-, -O-CO- oder -O-CO-O-ersetzt sein können, wobei auch ein oder mehrere H-Atome durch Fluor ersetzt sein können, eine Aryl-, Aryloxy-, Heteroaryl- oder Heteroaryloxygruppe mit 5 bis 40 C-Atomen, welche auch durch ein oder mehrere nicht-aromatische Reste R², R³, R⁴, R⁵, R⁷, R⁸, R⁹ und R¹⁰ substituiert sein kann; wobei auch zwei oder mehrere Reste R miteinander und/oder mit weiteren Resten R², R³, R⁴, R⁵, R⁷, R⁸, R⁹ und R¹⁰ ein aromatisches oder aliphatisches, mono- oder polycyclisches Ringsystem bilden können, welches auch mit dem Benzolring oder dem Thiophenring in Formel (I) oder (II) ein kondensiertes Ringsystem bilden kann,
- X: ist S oder O, und
worin die beiden Reste R¹ und R⁶ die Verknüpfung im Polymer bedeutet.

In einer bevorzugten Ausführungsform enthält das Polymer 0,01 bis 50 mol% einer Struktureinheit der Formel (I) oder (II) und besonders bevorzugt 0,01 bis 50 mol% einer Struktureinheit der Formel (I).

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 20 bis 5000 und insbesondere 50 bis 2000 Wiederholungseinheiten auf. Die erfindungsgemäßen oligomeren Verbindungen weisen vorzugsweise 2 bis 9 Wiederholungseinheiten auf. Der Verzweigungs-Faktor der Polymeren liegt dabei zwischen 0 (lineares Polymer, ohne Verzweigungsstellen) und 1 (vollständig verzweigtes Dendrimer).

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Struktureinheiten der Formel (I) und/oder (II) können erfindungsgemäß in die Haupt- oder in die Seitenkette des Polymers eingebaut werden. Bei Einbau in die Seitenkette besteht die Möglichkeit, dass die Struktureinheiten der Formel (I) und/oder (II) in Konjugation mit der Polymerhauptkette stehen oder dass sie nicht-konjugiert zur Polymerhauptkette sind. Vorzugsweise werden die Struktureinheiten der Formel (I) und/oder (II) in die Hauptkette des Polymers eingebaut.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette, aber auch Polymere mit Einheiten wie beispielsweise meta-verknüpftes Phenylen sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Des Weiteren wird in dieser Anmeldung ebenfalls als konjugiert bezeichnet, wenn sich in der Hauptkette beispielsweise Arylamineinheiten, Arylphosphineinheiten, bestimmte Heterocyclen (d. h. Konjugation über N-, O- oder S-Atome) und/oder metallorganische Komplexe (d. h. Konjugation über das Metallatom) befinden. Analoges gilt für konjugierte Dendrimere. Hingegen werden Einheiten wie beispielsweise einfache Alkylbrücken, (Thio)Ether-, Ester-, Amid- oder Imidverknüpfungen eindeutig als nicht-konjugierte Segmente definiert. Unter einem teilkonjugierten Polymer im Sinne der vorliegenden Anmeldung soll ein Polymer verstanden werden, das konjugierte Regionen enthält, die durch nicht konjugierte Abschnitte, gezielte Konjugationsunterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder sonstige Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

In einer weiteren bevorzugten Ausführungsform der vorliegenden Erfindung stehen Einheiten der Formel (I) und/oder (II) in Konjugation mit der Polymerhauptkette. Dies kann einerseits dadurch erreicht werden, dass diese Einheiten in die Hauptkette des Polymers so eingebaut werden, dass dadurch die Konjugation des Polymers, wie oben beschrieben, erhalten bleibt. Andererseits können diese Einheiten auch in die Seitenkette des Polymers so verknüpft werden, dass eine Konjugation zur Hauptkette des Polymers besteht. Dies ist z.B. der Fall, wenn die Verknüpfung mit der Hauptkette nur über sp²-hybridisierte (bzw. gegebenenfalls auch über sp-hybridisierte) Kohlenstoffatome, die auch durch entsprechende Heteroatome ersetzt sein können, erfolgt. Erfolgt die Verknüpfung jedoch durch Einheiten, wie z.B. einfache (Thio)Etherbrücken, Ester, Amide oder Alkylenketten, so sind die Einheiten der Formel (I) und/oder (II) als nicht-konjugiert zur Hauptkette definiert.

Die erfindungsgemäßen konjugierten, teilkonjugierten oder nicht-konjugierten Polymere und Dendrimere enthalten besonders bevorzugt von 0,1 bis 25 mol% und insbesondere 1 bis 15 mol%, einer oder mehrerer Einheiten der Formel (I) und/oder (II).

Die Begriffe "Alkyl", "Aryl", "Heteroaryl" etc. umfassen auch mehrbindige Gruppen, beispielsweise Alkylen, Arylen und Heteroarylen.

Der Begriff "Kohlenstoffrest" bedeutet vor- und nachstehend einen ein- oder mehrbindigen organischen Rest enthaltend mindestens ein Kohlenstoffatom, wobei dieser entweder keine weiteren Atome enthält (z.B. -C≡C-), oder gegebenenfalls ein oder mehrere weitere Atome wie beispielsweise N, O, S, P, Si, Se, As, Te oder Ge enthält (z.B. Carbonyl). Der Begriff "Kohlenwasserstoffrest" bedeutet einen Kohlenstoffrest, der zusätzlich ein oder mehrere H-Atome und gegebenenfalls ein oder mehrere Heteroatome wie beispielsweise N, O, S, P, Si, Se, As, Te oder Ge enthält.

Ein Kohlenstoff- oder Kohlenwasserstoffrest kann eine gesättigte oder ungesättigte Gruppe sein. Ungesättigte Gruppen sind beispielsweise Aryl-, Alkenyl- oder Alkinylgruppen. Ein Kohlenstoff- oder Kohlenwasserstoffrest mit mehr als 3 C-Atomen kann geradkettig, verzweigt und/oder cyclisch sein, und kann auch Spiroverknüpfungen oder kondensierte Ringe aufweisen.

Bevorzugte Kohlenstoff- und Kohlenwasserstoffreste sind gegebenenfalls substituiertes Alkyl, Alkenyl, Alkinyl, Alkoxy, Alkylcarbonyl, Alkoxycarbonyl, Alkylcarbonyloxy und Alkoxycarbonyloxy mit 1 bis 40, vorzugsweise 1 bis 25, besonders bevorzugt 1 bis 18 C-Atomen, gegebenenfalls substituiertes Aryl oder Aryloxy mit 6 bis 40, vorzugsweise 6 bis 25 C-Atomen, oder gegebenenfalls substituiertes Alkylaryl, Arylalkyl, Alkylaryloxy, Arylalkyloxy, Arylcarbonyl, Aryloxycarbonyl, Arylcarbonyloxy und Aryloxycarbonyloxy mit 6 bis 40, vorzugsweise 6 bis 25 C-Atomen.

Weitere bevorzugte Kohlenstoff- und Kohlenwasserstoffreste sind C₁-C₄₀ Alkyl, C₂-C₄₀ Alkenyl, C₂-C₄₀ Alkinyl, C₃-C₄₀ Allyl, C₄-C₄₀ Alkyldienyl, C₄-C₄₀ Polyenyl, C₆-C₄₀ Aryl, C₆-C₄₀ Alkylaryl, C₆-C₄₀ Arylalkyl, C₆-C₄₀ Alkylaryloxy, C₆-C₄₀ Arylalkyloxy, C₃-C₄₀ Heteroaryl, C₄-C₄₀ Cycloalkyl, C₄-C₄₀ Cycloalkenyl, etc.. Besonders bevorzugt sind C₁-C₂₂ Alkyl, C₂-C₂₂ Alkenyl, C₂-C₂₂ Alkinyl, C₃-C₂₂ Allyl, C₄-C₂₂ Alkyldienyl, C₆-C₁₂ Aryl, C₆-C₂₀ Arylalkyl und C₄-C₂₀ Heteroaryl.

Weitere bevorzugte Kohlenstoff- und Kohlenwasserstoffreste sind geradkettige, verzweigte oder cyclische Alkylreste mit 1 bis 40, vorzugsweise 1 bis 22 C-Atomen, welche unsubstituiert oder durch F, Cl, Br oder I ein- oder mehrfach substituiert sind, und worin ein oder mehrere nicht benachbarte CH₂-Gruppen jeweils unabhängig voneinander durch-C(R)=C(R)-, -C≡C-, -N(R)-, -O-, -S-, -CO-, -CO-O-, -O-CO- und/oder -O-CO-O- so ersetzt sein können, dass O- und/oder S-Atome nicht direkt miteinander verknüpft sind, wobei R die oben angegebene Bedeutung hat.

Bevorzugte Alkylgruppen sind z.B. Methyl, Ethyl, n-Propyl, Isopropyl, n-Butyl, Isobutyl, s-Butyl, t-Butyl, 2-Methylbutyl, n-Pentyl, s-Pentyl, Cyclopentyl, n-Hexyl, Cyclohexyl, 2-Ethylhexyl, n-Heptyl, Cycloheptyl, n-Octyl, Cyclooctyl, Dodecanyl, Trifluormethyl, Perfluor-n-butyl, 2,2,2-Trifluorethyl, Perfluoroctyl und Perfluorhexyl.

Bevorzugte Alkenylgruppen sind z.B. Ethenyl, Propenyl, Butenyl, Pentenyl, Cyclopentenyl, Hexenyl, Cyclohexenyl, Heptenyl, Cycloheptenyl, Octenyl und Cyclooctenyl.

Bevorzugte Alkinylgruppen sind z.B. Ethinyl, Propinyl, Butinyl, Pentinyl, Hexinyl und Octinyl.

Bevorzugte Alkoxygruppen sind z.B. Methoxy, Ethoxy, 2-Methoxyethoxy, n-Propoxy, i-Propoxy, n-Butoxy, i-Butoxy, s-Butoxy, t-Butoxy, 2-Methylbutoxy, n-Pentoxy, n-Hexoxy, n-Heptoxy und n-Octoxy.

Bevorzugte Aminogruppen sind z.B. Dimethylamin, Methylamin, Methylphenylamin und Phenylamin.

Der Begriff "Aryl" bedeutet eine aromatische Kohlenstoffgruppe oder eine davon abgeleitete Gruppe. Der Begriff "Heteroaryl" bedeutet "Aryl" gemäß vorstehender Definition, enthaltend ein oder mehrere Heteroatome.

Unter einem aromatischen bzw. heteroaromatischen Ringsystem im Sinne der vorliegenden Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nicht-aromatische Einheit (< 10 % der von H verschiedenen Atome, vorzugsweise < 5 % der von H verschiedenen Atome), wie beispielsweise C (sp³-hybridisiert), O und/oder N, unterbrochen sein können. So sollen beispielsweise auch Systeme wie 9,9' Spirobifluoren, 9,9-Diarylfluoren und Triarylamin als aromatische Ringsysteme verstanden werden.

Arylgruppen können monocyclisch oder polycyclisch sein, d.h. sie können einen Ring (z.B. Phenyl) oder zwei oder mehr Ringe aufweisen, welche auch kondensiert (z.B. Naphthyl) oder kovalent verknüpft sein können (z.B. Biphenyl), oder eine Kombination von kondensierten und verknüpften Ringen beinhalten. Bevorzugt sind vollständig konjugierte Arylgruppen.

Bevorzugte Arylgruppen sind z.B. Phenyl, Biphenyl, Triphenyl, [1,1':3',1"]Terphenyl-2'-yl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Bevorzugte Heteroarylgruppen sind z.B. 5-gliedrige Ringe wie z.B. Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie z.B. Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder kondensierte Gruppen wie z.B. Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen. Die Heteroarylgruppen können auch mit Alkyl, Alkoxy, Thioalkyl, Fluor, Fluoralkyl oder weiteren Aryl- oder Heteroarylgruppen substituiert sein.

Die Aryl-, Heteroaryl-, Kohlenstoff- und Kohlenwasserstoffreste weisen gegebenenfalls einen oder mehrere Substituenten auf, welche vorzugsweise ausgewählt sind aus der Gruppe bestehend aus Silyl, Sulfo, Sulfonyl, Formyl, Amin, Imin, Nitril, Mercapto, Nitro, Halogen, C₁₋₁₂ Alkyl, C₆₋₁₂ Aryl, C₁₋₁₂ Alkoxy, Hydroxy oder Kombinationen dieser Gruppen.

Bevorzugte Substituenten sind beispielsweise löslichkeitsfördernde Gruppen wie Alkyl oder Alkoxy, elektronenziehende Gruppen wie Fluor, Nitro oder Nitril, oder Substituenten zur Erhöhung der Glastemperatur (Tg) im Polymer, insbesondere voluminöse Gruppen wie z.B. t-Butyl oder gegebenenfalls substituierte Arylgruppen.

Besonders bevorzugte Substituenten sind z.B. F, Cl, Br, I, -CN, -NO₂, -NCO, -NCS, -OCN, -SCN, -C(=O)N(R)₂, -C(=O)Y¹, -C(=O)R und -N(R)₂, worin R die oben angegebene Bedeutung hat und Y¹ Halogen bedeutet, optional substituiertes Silyl, Aryl mit 4 bis 40, vorzugsweise 6 bis 20 C-Atomen, und geradkettiges oder verzweigtes Alkyl, Alkoxy, Alkylcarbonyl, Alkoxycarbonyl, Alkylcarbonyloxy oder Alkoxycarbonyloxy mit 1 bis 22 C-Atomen, worin ein oder mehrere H-Atome gegebenenfalls durch F oder Cl ersetzt sein können.

"Halogen" bedeutet F, Cl, Br oder I.

Aryl(oxy)- und Heteroaryl(oxy)reste sind vorzugsweise ein- oder mehrfach, wie oben definiert, substituiert.

Ganz besonders bevorzugt sind Polymere enthaltend Struktureinheiten der Formel (I) ausgewählt aus den folgenden Unterformeln: 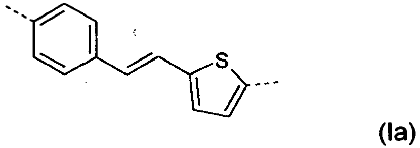 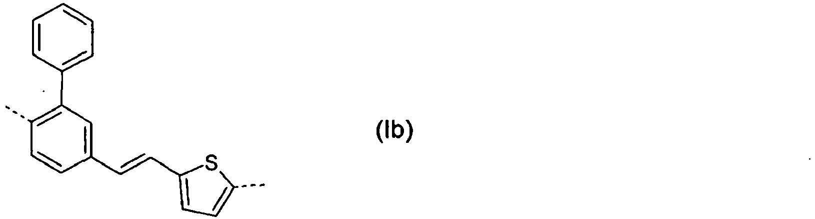 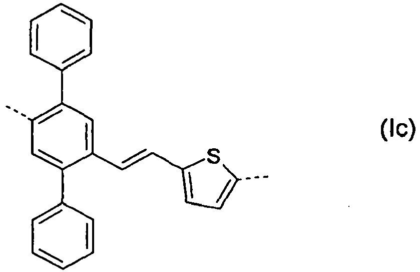 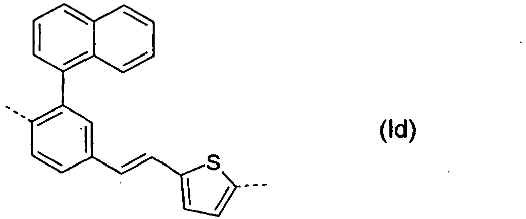 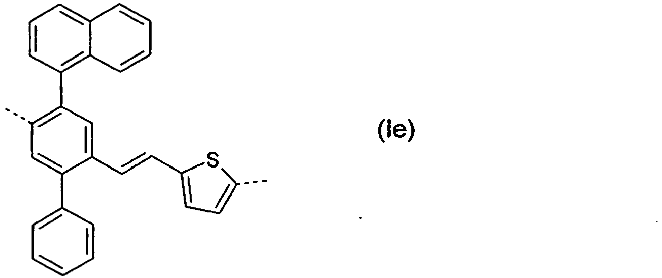 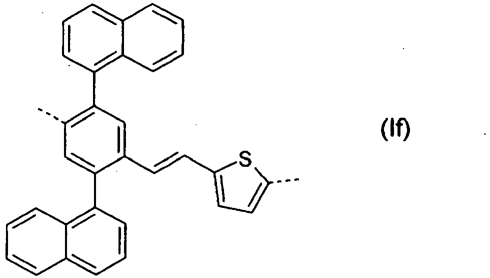 wobei die gestrichelten Linien am Thiophen- und am Phenylring die Verknüpfung im Polymer darstellen (und keine Methylgruppen). Mögliche und/oder bevorzugte weitere Substituenten R sind der Übersichtlichkeit wegen nicht angegeben.

Für Polymere enthaltend Struktureinheiten der Formel (II) sind die gleichen Unterformeln ganz besonders bevorzugt, wie oben für die Struktureinheiten der Formel (I) abgebildet.

Die erfindungsgemäßen Polymere können neben einer oder mehrerer Struktureinheiten der Formel (I) und/oder (II) noch weitere Struktureinheiten enthalten. Dies sind u. a. solche, wie sie z.B. in der WO 02/077060 A1 und in der WO 2005/014689 A2 offenbart und umfangreich aufgelistet sind. Diese werden via Zitat als Bestandteil der vorliegenden Erfindung betrachtet. Die weiteren Struktureinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom so genannten Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Backbone verwendet werden;
- Gruppe 8:: Einheiten, welche die filmmorphologischen Eigenschaften und/oder die rheologischen der resultierenden Polymere beeinflussen.

Bevorzugte erfindungsgemäße Polymere sind solche, bei denen mindestens eine Struktureinheit Ladungstransporteigenschaften aufweist, d.h. die Einheiten aus den Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen mit hoch liegendem HOMO (HOMO = höchstes besetztes Molekülorbital). Vorzugsweise führen diese Arylamine und Heterocyclen zu einem HOMO im Polymer von mehr als -5,8 eV (gegen Vakuumlevel), besonders bevorzugt von mehr als -5,5 eV.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen mit niedrig liegendem LUMO (LUMO = niedrigstes unbesetztes Molekülorbital). Vorzugsweise führen diese Einheiten im Polymer zu einem LUMO von weniger als -2,5 eV (gegen Vakuumlevel), besonders bevorzugt von weniger als -2,7 eV.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten aus der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Struktureinheiten, welche Elemente der Gruppe 8 bis 10 (Ru, Os, Rh, Ir, Pd, Pt) enthalten. Als Struktureinheiten für die erfindungsgemäßen Polymeren kommen hier z.B. verschiedene Komplexe in Frage, wie sie z.B. in der WO 02/068435 A1, der WO 02/081488 A1, der EP 1239526 A2 und der WO 2004/026886 A2 offenbart werden. Entsprechende Monomere werden in der WO 02/068435 A1 und in der WO 2005/042548 A1 offenbart.

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 offenbart werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 offenbart werden.

Struktureinheiten der Gruppe 6 sind neben den oben genannten solche, die mindestens noch eine weitere aromatische oder eine andere konjugierte Struktur aufweisen, welche nicht unter die o.g. Gruppen fallen, d.h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4 Phenylen-, 1,4-Naphthylen-, 1,4- oder 9,10-Anthrylen-, 1,6-, 2,7- oder 4,9-Pyrenylen-, 3,9- oder 3,10- Perylenylen-, 4,4'-Biphenylylen-, 4,4" Terphenylylen-, 4,4'-Bi-1,1'-naphthylylen-, 4,4'-Tolanylen-, 4,4'-Stilbenylen-, 4,4" Bisstyrylarylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate.

Struktureinheiten der Gruppe 8 sind solche, die die filmmorphologischen Eigenschaften und/oder die rheologischen der Polymere beeinflussen, wie z.B. Siloxane, lange Alkylketten oder fluorierte Gruppen, aber auch besonders steife oder flexible Einheiten, wie z.B. flüssigkristallbildende Einheiten oder vernetzbare Gruppen.

Bevorzugt sind erfindungsgemäße Polymere, die gleichzeitig neben Struktureinheiten der Formel (I) und/oder (II) zusätzlich noch ein oder mehrere Einheiten ausgewählt aus den Gruppen 1 bis 8 enthalten. Es kann ebenfalls bevorzugt sein, wenn gleichzeitig mehr als eine Struktureinheit aus einer Gruppe vorliegt.

Aber auch ein kleinerer Anteil der emittierenden Einheiten, insbesondere grün und rot emittierender Einheiten, kann bevorzugt sein, beispielsweise zur Synthese von weiß emittierenden Copolymeren. Wie weiß emittierende Copolymere synthetisiert werden können, ist im Detail z.B. in der WO 2005/030827 A1 und WO 2005/030828 A1 offenbart.

Bevorzugt sind dabei erfindungsgemäße Polymere, die neben mindestens einer Struktureinheit der Formel (I) und/oder (II) noch Einheiten aus der Gruppe 7 enthalten, besonders bevorzugt mindestens 50 mol% dieser Einheiten.

Ebenfalls bevorzugt ist es, wenn die erfindungsgemäßen Polymere Einheiten enthalten, die den Ladungstransport oder die Ladungsinjektion verbessern, also Einheiten aus der Gruppe 1 und/oder 2; besonders bevorzugt ist ein Anteil von 0,5 bis 30 mol% dieser Einheiten; ganz besonders bevorzugt ist ein Anteil von 1 bis 10 mol% dieser Einheiten.

Besonders bevorzugt ist es weiterhin, wenn die erfindungsgemäßen Polymere Struktureinheiten aus der Gruppe 7 und Einheiten aus der Gruppe 1 und/oder 2 enthalten, insbesondere mindestens 50 mol% Einheiten aus der Gruppe 7 und 0,5 bis 30 mol% Einheiten aus der Gruppe 1 und/oder 2.

Die nötige Löslichkeit der Polymere wird vor allem durch die Substituenten an den verschiedenen Wiederholungseinheiten gewährleistet, sowohl den Substituenten R¹⁻¹⁰ an den Struktureinheiten der Formel (I) und/oder (II), als auch durch Substituenten an den anderen Wiederholungseinheiten.

Die erfindungsgemäßen Polymere sind entweder Homopolymere aus Struktureinheiten der Formel (I) und/oder (II) oder Copolymere. Die erfindungsgemäßen Polymere können linear, verzweigt oder vernetzt sein. Erfindungsgemäße Copolymere können dabei neben einer oder mehreren Struktureinheiten der Formel (I) und/oder (II), oder deren bevorzugten Unterformeln, potentiell eine oder mehrere weitere Strukturen aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

Die erfindungsgemäßen Polymere mit Struktureinheiten der Formel (I) und/oder (II) sind gut und in hohen Ausbeuten zugänglich. Sie zeigen im Feststoff vorzugsweise blaue Lumineszenz.

Die erfindungsgemäßen Polymere weisen vorteilhafte Eigenschaften, insbesondere hohe Lebensdauern, hohe Effizienzen und gute Farbkoordinaten auf.

Die erfindungsgemäßen Polymere werden in der Regel durch Polymerisation von einer oder mehreren Monomersorten hergestellt, von denen mindestens ein Monomer im Polymer zu Struktureinheiten der Formel (I) und/oder (II) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) Polymerisation gemäß SUZUKI;
(B) Polymerisation gemäß YAMAMOTO;
(C) Polymerisation gemäß STILLE;
(D) Polymerisation gemäß HECK;
(E) Polymerisation gemäß NEGISHI;
(F) Polymerisation gemäß SONOGASHIRA;
(G) Polymerisation gemäß HIYAMA; und
(H) Polymerisation gemäß HARTWIG-BUCHWALD.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Die erfindungsgemäßen Polymeren können durch ein Verfahren hergestellt werden, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden.

Die erfindungsgemäßen Dendrimere können gemäß dem Fachmann bekannten Verfahren oder in Analogie dazu hergestellt werden. Geeignete Verfahren sind in der Literatur beschrieben, wie z.B. in Frechet, Jean M. J.; Hawker, Craig J., "Hyperbranched polyphenylene and hyperbranched polyesters: new soluble, three-dimensional, reactive polymers", Reactive & Functional Polymers (1995), 26(1-3), 127-36; Janssen, H. M.; Meijer, E. W., "The synthesis and characterization of dendritic molecules", Materials Science and Technology (1999), 20 (Synthesis of Polymers), 403-458; Tomalia, Donald A., "Dendrimer molecules", Scientific American (1995), 272(5), 62-6, WO 02/067343 A1 und WO 2005/026144 A1.

Zur Synthese der erfindungsgemäßen Polymere werden die entsprechenden Monomere benötigt. Monomere, die in den erfindungsgemäßen Polymeren zu Struktureinheiten der Formel (I) oder (II) führen, sind 2-Vinylthiophenylbenzolderivate, die gegebenenfalls entsprechend substituiert sind und an einer, zwei, drei oder vier, vorzugsweise 2 Positionen geeignete Funktionalitäten aufweisen, die es erlauben, diese Monomereinheit in das Polymer einzubauen. Diese Monomere sind neu und daher ebenfalls Gegenstand der vorliegenden Erfindung.

Gegenstand der vorliegenden Erfindung sind somit weiterhin Verbindungen der Formel (III) und (IV), 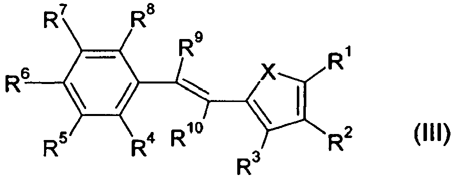 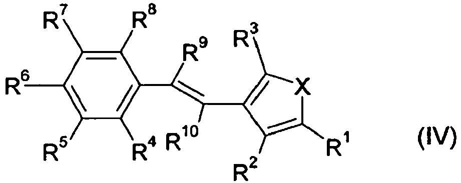 die dadurch gekennzeichnet sind, dass die Reste R¹ und R⁶, gleich oder verschieden, funktionelle Gruppen sind, die unter Bedingungen der C-C-bzw. C-N-Verknüpfungen polymerisieren, ausgewählt aus Cl, Br, I, O-Tosylat, O-Triflat, O-SO₂R¹², B(OR¹²)₂ und Sn(R¹²)₃, besonders bevorzugt aus Br, I und B(OR¹²)₂, wobei R¹² bei jedem Auftreten gleich oder verschieden H, ein aliphatischer oder aromatischer Kohlenwasserstoffrest mit 1 bis 20 C-Atomen ist, und wobei zwei oder mehrere Reste R¹² auch miteinander ein Ringsystem bilden können, und wobei die weiteren Symbole und Indices dieselbe Bedeutung wie in Bezug auf die Struktureinheiten der Formel (I) und (II) haben.

Dabei gilt für die bifunktionellen monomeren Verbindungen der Formel (III) und (IV) dieselbe Bevorzugung wie sie für die Struktureinheiten der Formel (I) und (II) oben beschrieben ist.

Die Synthese der oben beschriebenen Einheiten aus der Gruppe 1 bis 8 sowie der weiteren emittierenden Einheiten ist dem Fachmann bekannt und in der Literatur, z.B. in der WO 2005/014689 A2, der WO 2005/030827 A1 und WO 2005/030828 A1, beschrieben. Diese Dokumente und die darin zitierte Literatur sind via Zitat Bestandteil der vorliegenden Anmeldung.

Es kann außerdem bevorzugt sein, die erfindungsgemäßen Polymere nicht als Reinsubstanz, sondern als Blend (Mischung) zusammen mit weiteren beliebigen polymeren, oligomeren, dendritischen oder niedermolekularen Substanzen zu verwenden. Diese können z.B. die elektronischen Eigenschaften verbessern oder selber emittieren. Als "Blend" wird vor- und nachstehend eine Mischung enthaltend mindestens eine polymere Komponente bezeichnet.

Ein weiterer Gegenstand der vorliegenden Erfindung ist somit eine Polymermischung (Blend) enthaltend ein oder mehrere erfindungsgemäße Polymere, sowie eine oder mehrere weitere polymere, oligomere, dendritische und/oder niedermolekulare Substanzen.

Gegenstand der Erfindung sind weiterhin Lösungen und Formulierungen aus einem oder mehreren erfindungsgemäßen Polymeren oder Blends in einem oder mehreren Lösungsmitteln. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Struktureinheiten der Formel (I) und/oder (II), welche eine oder mehrere polymerisierbare, und damit vernetzbare Gruppen enthalten, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Besonders bevorzugt für solche Anwendungen sind erfindungsgemäße Polymere mit einer oder mehreren vernetzbaren Gruppen, ausgewählt aus Acrylat, Methacrylat, Vinyl, Epoxy und Oxetan. Dabei können sowohl entsprechende Polymere in Reinsubstanz verwendet werden, es können aber auch Formulierungen oder Blends dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 offenbart. Mögliche Bindemittel sind beispielsweise Polystyrol, Polycarbonat, Polyacrylate, Polyvinylbutyral und ähnliche, optoelektronisch neutrale Polymere.

Geeignete und bevorzugte Lösungsmittel sind beispielsweise Toluol, Anisol, Xylol, Methylbenzoat, Dimethylanisol, Mesitylen, Tetralin, Veratrol und Tetrahydrofuran.

Die erfindungsgemäßen Polymere, Blends und Formulierungen können in elektronischen oder optoelektronischen Vorrichtungen bzw. zu deren Herstellung verwendet werden.

Ein weiterer Gegenstand der vorliegenden Erfindung ist somit die Verwendung der erfindungsgemäßen Polymeren, Blends und Formulierungen in elektronischen oder optoelektronischen Vorrichtungen, vorzugsweise in organischen bzw. polymeren organischen Leuchtdioden (OLED, PLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen bzw. polymeren organischen Leuchtdioden (OLED, PLED), insbesondere in polymeren organischen Leuchtdioden (PLED).

Wie OLEDs bzw. PLEDs hergestellt werden können, ist dem Fachmann bekannt und wird beispielsweise als allgemeines Verfahren ausführlich in der WO 2004/070772 A2 offenbart, das entsprechend für den Einzelfall anzupassen ist.

Wie oben beschrieben, eignen sich die erfindungsgemäßen Polymeren ganz besonders als Elektrolumineszenzmaterialien in derart hergestellten PLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Ein bevorzugter Gegenstand der vorliegenden Erfindung ist daher auch die Verwendung der erfindungsgemäßen Polymeren oder Blends in einer PLED, insbesondere als Elektrolumineszenzmaterial.

Gegenstand der vorliegenden Erfindung sind ferner elektronische oder optoelektronische Bauteile, vorzugsweise organische bzw. polymere organische Leuchtdioden (OLED, PLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen oder organische Photorezeptoren (OPCs), besonders bevorzugt organische bzw. polymere organische Leuchtdioden, insbesondere polymere organische Leuchtdioden, mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht, eine Ladungstransportschicht und/oder eine Ladungsinjektionsschicht sein.

Im vorliegenden Anmeldungstext und auch in den im Weiteren folgenden Beispielen wird hauptsächlich auf die Verwendung der erfindungsgemäßen Polymeren in Bezug auf PLEDs und entsprechende Displays abgezielt. Trotz dieser Beschränkung der Beschreibung ist es für den Fachmann ohne weiteres erfinderisches Zutun möglich, die erfindungsgemäßen Polymere als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele 1 und 2: Monomer-Beispiele

### Beispiel 1

### Herstellung von 4-(5-Brom-2-vinylthiophenyl)-1-brombenzol 3

Die Verbindung wird wie folgt hergestellt:

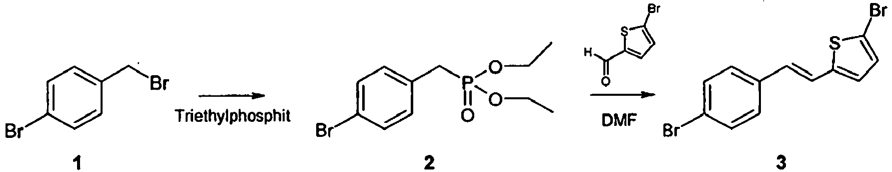

### 1.1 (4-Brombenzyl)-phosphonsäurediethylester 2

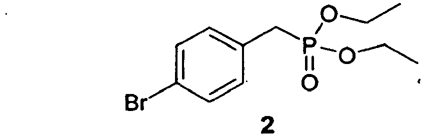

40,69 g (1 molares Äquivalent, 163 mmol) 4-Brombenzylbromid **1** werden in 28,3 ml (1 molares Äquivalent, 163 mmol) Triethylphosphit bis zur Beendigung der Gasentwicklung auf 160°C erhitzt. Der Ansatz wird unter Vakuum destilliert und der verbleibende Rückstand in Form eines Öls **2** (48,87 g, 98 %) wird ohne weitere Reinigung in die Folgereaktion eingesetzt.
¹H NMR (CDCl₃, δ (ppm), *J* (Hz)): 1,25 (t, 6H, J = 7,1), 3,07 (s, 1H), 3,11 (s, 1H), 4,01 (m, 4H), 7,17 (d, 2H, J = 8,4), 7,43 (d, 2H, J = 8,4).

### 1.2 4-(5-Brom-2-vinythiophenyl)-1-brombenzol 3

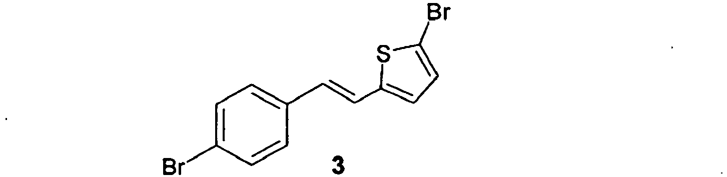

30 g (1 molares Äquivalent, 98 mmol) (4-Brombenzyl)-phosphonsäurediethylester **2** werden in 500 ml Dimethylformamid (DMF) vorgelegt, unter Schutzgas bei ca. 0°C mit 18,78 g Natrium *tert*-butylat (2 molare Äquivalente, 196 mmol) versetzt und nach 30 Minuten Rührzeit bei 0°C eine Lösung von 21,61 g (1,1 molare Äquivalente, 107 mmol) 5-Brom-2-carbaldehydthiophen in 150 ml DMF langsam bei 0°C zugetropft. Nach 1 Stunde wird bei 5°C 200 ml Ethanol und 150 ml Wasser zugetropft, bei Raumtemperatur über Nacht gerührt, der Niederschlag abgesaugt, mit Methanol gewaschen und getrocknet. Nach Umkristallisation aus Methanol erhält man das Produkt **3** (18,23 g, 54 %).
¹H NMR (CDCl₃, δ (ppm), *J* (Hz)): 6,74 (d, 1H, *J* = 16), 6,81 (d, 1H, *J* = 3,9), 6,96 (d, 1H, *J* = 3,9), 7,09 (d, 1H, *J* = 16), 7,31 (d, 2H, *J* = 8,5), 7,45 (d, 2H, *J* = 8,5).

### Beispiel 2 (Referenzbeispiel)

### Herstellung von 4-(5-Brom-2-vinylthiophenyl)-3-(2,5-dimethylphen-1-yl)-1-brombenzol 10

Die Verbindung wird wie folgt hergestellt:

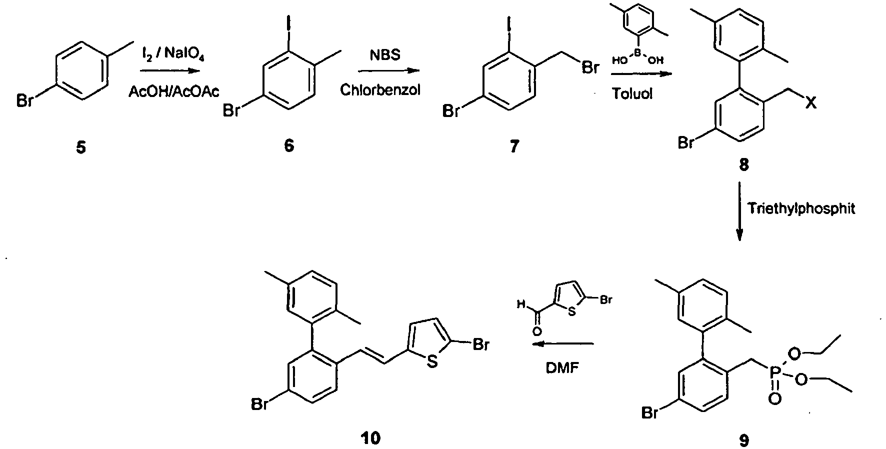

### 2.1 2-Iod-4-brom-toluol 6

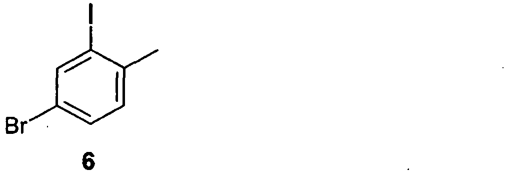

Natriumperiodat (0,5 molare Äquivalente, 102,5 g, 0,48 mol) und Iod (0,3 molare Äquivalente, 81,6 g, 0,32 mol) werden in Essigsäure (700 ml) und Essigsäureanhydrid (340 ml) suspendiert. Der Ansatz wird dann auf 10°C gekühlt und bei dieser Temperatur wird Schwefelsäure (2,9 molare Äquivalente, 142 ml, 2,66 mol) langsam zugetropft. Bei Raumtemperatur wird anschließend 4-Bromtoluol **5** (1 molares Äquivalent, 160,7 g, 0,94 mol) langsam zugetropft und der Ansatz wird über Nacht gerührt. Nach Zugabe von gekühltem Wasser (1000 ml) und einer Lösung aus Na₂SO₃ (169 g in 1000 ml) wird die Mischung mit Dichlormethan (DCM) ausgeschüttelt. Die organische Phase wird mit Wasser gewaschen, getrocknet und einrotiert. Das Produkt **6** (188,0 g, 67 %) erhält man durch Vakuum-Destillation in Form einer Flüssigkeit.
¹H NMR (CDCl₃, δ (ppm), *J* (Hz)): 2,39 (s, 3H), 7,10 (d, 1H, *J* = 8,2), 7,37 (dd, 1H, *J*₁ = 2,0, *J*₂ = 8,2), 7,95 (d, 1H, *J* = 2,0).

### 2.2 2-Iod-4-brom-brommethylbenzol 7

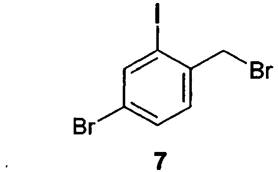

Zu einer Lösung aus 2-Iod-4-bromtoluol **6** (1 molares Äquivalent, 100,3 g, 338 mmol) in Chlorbenzol (1200 ml) werden N-Bromsuccinimid (NBS) (1,1 molare Äquivalente, 66,5 g, 373 mmol) und Benzylperoxid (0,006 molare Äquivalente, 450,7 mg, 1,9 mmol) zugegeben. Der Ansatz wird dann über Nacht am Rückfluss gerührt. Nachdem das Lösungsmittel abrotiert ist, werden Ethylacetat und Wasser zugegeben. Die wässrige Phase wird mit Ethylacetat ausgeschüttelt. Die organische Phase wird mit Wasser ausgeschüttelt, getrocknet und einrotiert. Man erhält das Produkt **7** (30,7 g, 24 %) durch Umkristallisation aus Ethanol (50 ml) in Form eines weißen Pulvers.
¹H NMR (CDCl₃, δ (ppm), *J* (Hz)): 4,54 (s, 2H), 7,34 (d, 1H, *J* = 8,1), 7,47 (dd, 1H, *J*₁ = 1, 9, *J*₂ = 8,1), 8,01 (d, 1H, *J* = 1,9).

### 2.3 4-Brom-2-(2,5-dimethylphen-1-yl)-brommethylbenzol 8

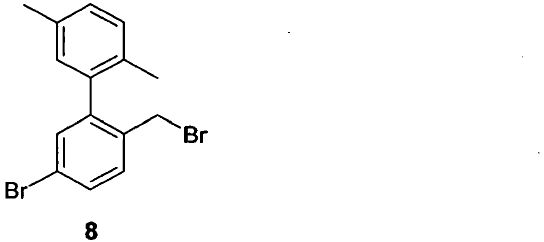

Eine Lösung aus 2-Iod-4-brom-brommethylbenzol **7** (1 molares Äquivalent, 30,5 g, 81 mmol), 2,5-Dimethylphenylboronsäure (1 molares Äquivalent, 12,2 g, 81 mmol) und Kaliumcarbonat (5 molare Äquivalente, 56 g, 405 mmol) in Toluol (420 ml) und Wasser (360 ml) wird während 30 Minuten unter Schutzgas gerührt. Pd(PPh₃)₄ (0,005 molare Äquivalente, 458 mg, 0,4 mmol) wird zugegeben und der Ansatz wird während 17 Stunden am Rückfluss gerührt. Die Mischung wird mit Toluol ausgeschüttelt. Die organische Phase wird getrocknet und einrotiert. Das Produkt 8 (9,28 g, 32 %) erhält man durch Reinigung über eine KieselgelSäule (Laufmittel: Heptan) in Form eines leicht gelblichen Öls.
¹H NMR (CDCl₃, δ (ppm), *J* (Hz)): 2,06 (s, 3H), 2,35 (s, 3H), 4,08 (d, 1H, *J* = 9,4), 4,31 (d,1H, *J =* 9,4), 6,99 (s, 1H), 7,13 (d, 1H, *J =* 7,7), 7,18 (d, 1H, *J =* 7,7), 7,25 (d,1H, *J =* 2,0), 7,40 (d,1H, *J =* 8,3), 7,44 (dd, 1H, *J*₁ = 2,0, *J*₂ = 8,3).

### 2.4 [4-Brom-2-(2,5-dimethylphen-1-yl)-benzyl]-phosphonsäurediethylester 9

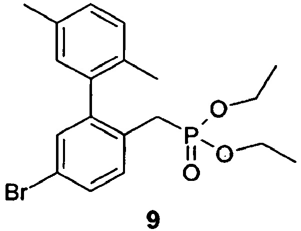

8,29 g (1 molares Äquivalent, 23 mmol) 4-Brom-2-(2,5-dimethylphen-1-yl)-brommethylbenzol **8** werden in 4,4 ml (1,1 molare Äquivalente, 26 mmol) Triethylphosphit bis zur Beendigung der Gasentwicklung auf 180°C erhitzt. Der Ansatz wird unter Vakuum destilliert und der verbleibende Rückstand in Form eines farblosen Öls **9** (8,6 g, 89 %) wird ohne weitere Reinigung in die Folgereaktion eingesetzt.
¹H NMR (CDCl₃, δ (ppm), *J* (Hz)): 1,20-1,24 (m, 6H), 2,01 (s, 3H), 2,33 (s, 3H), 3,01-2,83 (m, 2H), 3,97-3,90 (m, 4H), 6,96 (s, 1H), 7,09 (d, 1H, *J =* 7,9), 7,14 (d, 1H, *J =* 7,7), 7,30 (s, 1H), 7,44 (dd, 1H, *J*₁ = 2,2, *J*₂ = 8,4), 7,48 (dd, 1H, *J*₁ = 2,5, *J*₂ = 8,4).

### 2.5 4-(5-Brom-2-vinylthiophenyl)-3-(2,5-dimethylphen-1-yl)-1-brombenzol 10

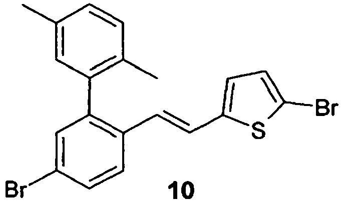

6,06 g (1 molares Äquivalent, 15 mmol) [4-Brom-2-(2,5-dimethylphen-1-yl)-benzyl]-phosphonsäurediethylester 9 werden in 70 ml DMF vorgelegt, unter Schutzgas bei ca. 0°C mit 3,12 g Natrium *tert*-butylat (2,2 molare Äquivalente, 33 mmol) versetzt und nach 40 Minuten Rührzeit bei 0°C eine Lösung von 2,99 g (1,1 molare Äquivalente, 16 mmol) 5-Brom-2-carbaldehydthiophen in 40 ml DMF langsam bei 0°C zugetropft. Nach 2 Stunden wird bei 5°C Ethanol und Wasser zugetropft, bei Raumtemperatur über Nacht gerührt und der Ansatz mit DCM ausgeschüttelt. Die organischen Phasen werden getrennt, mit Wasser gewaschen, getrocknet und einrotiert. Nach Umkristallisation aus Acetonitril erhält man das Produkt 10 (1,29 g, 20 %) in Form eines leicht gelblichen Pulvers.
¹H NMR (CDCl₃, δ (ppm), *J* (Hz)): 2,01 (s, 3H), 2,36 (s, 3H), 6,42 (d, 1H, *J* = 16,0), 6,69 (d, 1H, *J* = 3,7), 6,88 (d, 1H, *J* = 3,8), 6,94 (s, 1H), 6,99 (d, 1H, *J* = 16,0), 7,17-7,12 (m, 2H), 7,34 (d, 1H, *J =* 2,0), 7,46 (dd, 1H, *J*₁ = 8,6, *J*₂ = 2,0) 7,53 (d, 1H, *J* = 8,6).

### Beispiele 3 bis 6: Polymer-Beispiele

Die erfindungsgemäßen Polymere P1 bis P3 sowie das Vergleichspolymer V1 werden unter Verwendung der folgenden Monomeren (Prozentangaben = mol%) durch SUZUKI-Kupplung gemäß der WO 03/048225 A2 synthetisiert.

### Beispiel 3 (Polymer P1)

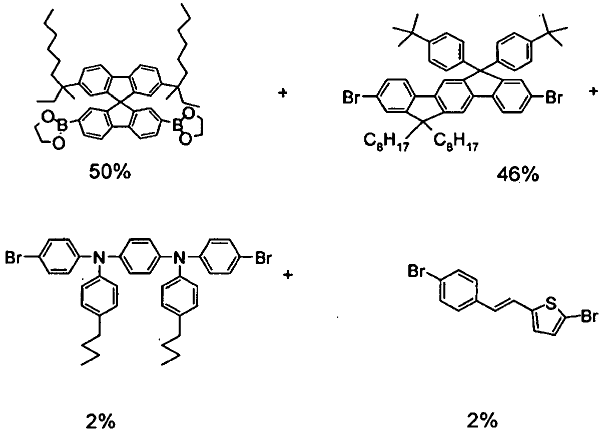

### Beispiel 4 (Polymer P2) (Referenzbeispiel)

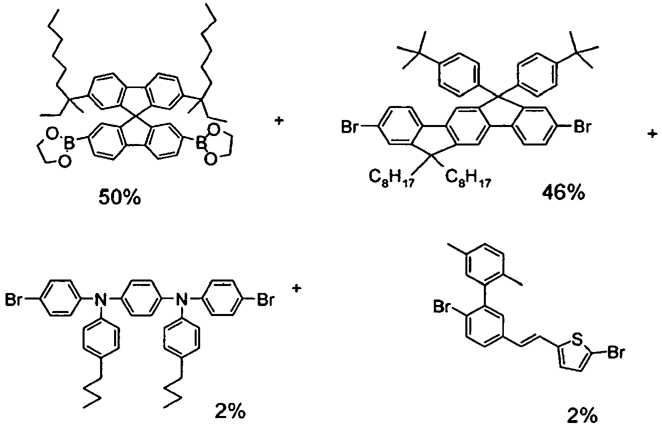

### Beispiel 5 (Polymer P3)

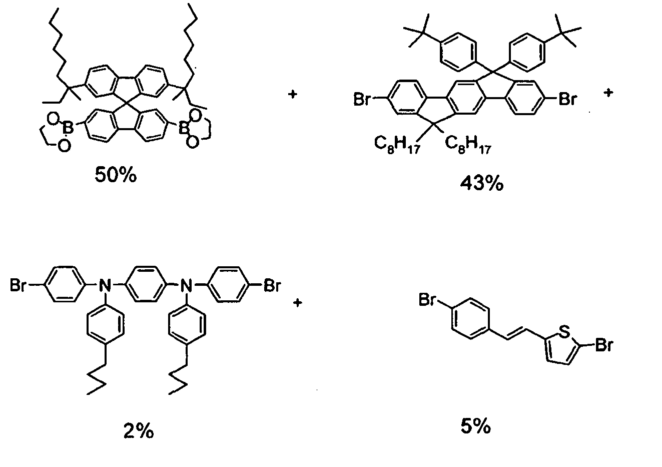

### Beispiel 6 (Veraleichspolymer V1)

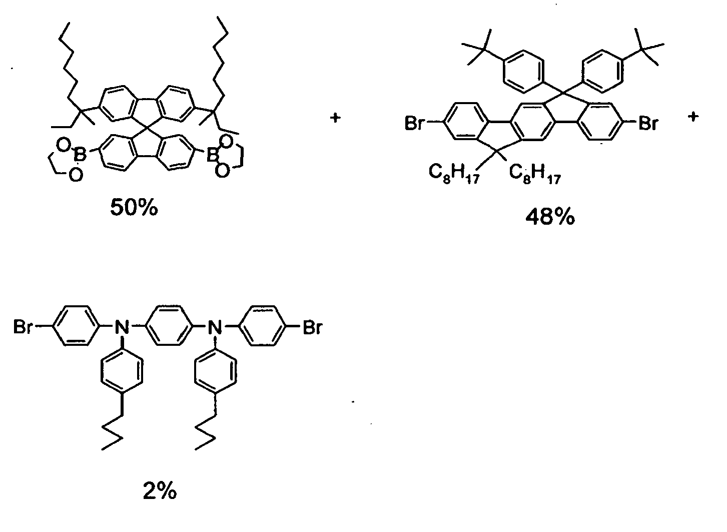

### Beispiele 7 bis 10: Device-Beispiele

### Herstellung von PLEDs

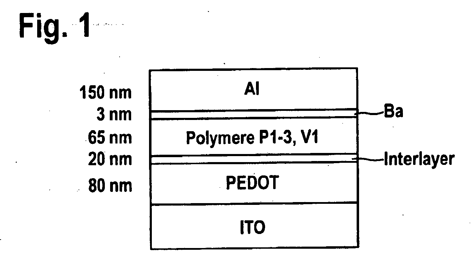

Die Herstellung einer polymeren organischen Leuchtdiode (PLED) ist in der Literatur bereits vielfach beschrieben (z.B. in der WO 2004/037887 A2). Um die vorliegende Erfindung beispielhaft zu erläutern, werden PLEDs mit den Polymeren P1 bis P3 sowie dem Vergleichspolymer V1 durch Spincoating hergestellt. Eine typische Device hat den in Figur 1 dargestellten Aufbau.

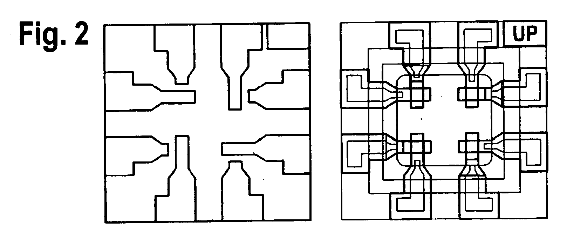

Dazu werden speziell angefertigte Substrate der Firma Technoprint in einem eigens zu diesem Zweck designten Layout verwendet (Figur 2, Abbildung links: Auf den Glasträger aufgebrachte ITO-Struktur, Abbildung rechts: Vollständige elektronische Struktur mit ITO, aufgedampter Kathode und optionaler Metallisierung der Zuleitungen). Die ITO-Struktur (Indium-Zinn-Oxid, eine transparente, leitfähige Anode) wurde durch Sputtern in einem solchen Muster auf Sodalimeglas aufgebracht, dass sich mit der am Ende des Herstellungsprozesses aufgedampften Kathode 4 Pixel à 2 x 2 mm ergeben.

Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spincoater-Geometrie ab (typisch für 80 nm: 4500 rpm). Um Restwasser aus der Schicht zu entfernen, werden die Substrate für 10 Minuten bei 180°C auf einer Heizplatte ausgeheizt. Danach werden unter Inertgasatmosphäre (Stickstoff bzw. Argon) zunächst 20 nm einer Interlayer (typischerweise ein lochdominiertes Polymer, hier HIL-012 von Merck) und dann 65 nm der Polymerschichten aus Toluollösungen (Konzentration Interlayer 5 g/l, für die Polymere P1 bis P3 und V1 jeweils 8 g/l) aufgebracht. Beide Schichten werden bei 180°C mindestens 10 Minuten ausgeheizt. Danach wird die Ba/Al-Kathode im angegebenen Muster durch eine Aufdampfmaske aufgedampft (hochreine Metalle von Aldrich, besonders Barium 99,99 % (Best-Nr. 474711); Aufdampfanlagen von Lesker o.a., typischer Vakuumlevel 5 x 10⁻⁶ mbar). Um vor allem die Kathode vor Luft und Luftfeuchtigkeit zu schützen, wird die Device abschließend verkapselt. Die Verkapselung der Device erfolgt, indem ein kommerziell erhältliches Deckglas über der pixelierten Fläche verklebt wird. Anschließend wird die Device charakterisiert.

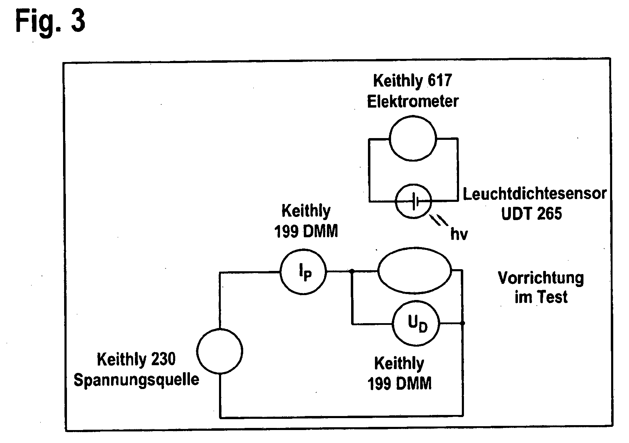

Dazu werden die Devices in für die Substratgröße eigens angefertigte Halter eingespannt und mittels Federkontakten kontaktiert. Eine Photodiode mit Augenverlaufsfilter kann direkt auf den Messhalter aufgesetzt werden, um Einflüsse von Fremdlicht auszuschließen. Der typische Messaufbau ist in Figur 3 dargestellt.

Typischerweise werden die Spannungen von 0 bis max. 20 V in 0,2 V-Schritten erhöht und wieder erniedrigt. Für jeden Messpunkt wird der Strom durch die Device sowie der erhaltene Photostrom von der Photodiode gemessen. Auf diese Art und Weise erhält man die IVL-Daten der Testdevices. Wichtige Kenngrößen sind die gemessene maximale Effizienz ("Max. Eff." in cd/A) und die für 100 cd/m² benötigte Spannung.

Um außerdem die Farbe und das genaue Elektrolumineszenzspektrum der Testdevices zu kennen, wird nach der ersten Messung nochmals die für 100 cd/m² benötigte Spannung angelegt und die Photodiode durch einen Spektrum-Messkopf ersetzt. Dieser ist durch eine Lichtleitfaser mit einem Spektrometer (Ocean Optics) verbunden. Aus dem gemessenen Spektrum können die Farbkoordinaten (CIE: Commission International de l'eclairage, Normalbetrachter von 1931) abgeleitet werden.

Für die Einsatzfähigkeit der Materialien von besonderer Bedeutung ist die Lebensdauer der Devices. Diese wird in einem der Erstevaluierung sehr ähnlichen Messaufbau so gemessen, dass eine Anfangsleuchtdichte eingestellt wird (z.B. 1000 cd/m²). Der für diese Leuchtdichte benötigte Strom wird konstant gehalten, während typischerweise die Spannung ansteigt und die Leuchtdichte abnimmt. Die Lebensdauer ist erreicht, wenn die Anfangsleuchtdichte auf 50% des Ausgangswertes abgesunken ist.

Die Ergebnisse, die bei Verwendung der Polymeren P1 bis P3 sowie V1 in PLEDs erhalten werden, sind in Tabelle 1 zusammengefasst.

**Tabelle 1**

| Beispiel | Polymer | Max. Eff. [cd/A] | U @ 100 cd/m² [V] | CIE [x/y] | Lebensdauer [h @ cd/m²] |
|---|---|---|---|---|---|
| 7 | P1 | 8,35 | 5,29 | 0,17/0,33 | 1000 @ 1000 |
| 8^{(*)} | P2 | 8,85 | 4,89 | 0,17/0,30 | 1200 @ 1000 |
| 9 | P3 | 12,09 | 4,63 | 0,19/0,36 | 1500 @ 1000 |
| 10 | V1 | 4,57 | 5,04 | 0,15/0,15 | 80 @ 1000 |

| | | | | | |
|---|---|---|---|---|---|
| ^{(*)} Referenzbeispiel | | | | | |

Wie man aus den Ergebnissen erkennen kann, stellen die Polymere P1 und P3 eine deutliche Verbesserung in Effizienz und Lebensdauer gegenüber dem Vergleichspolymer dar. Dadurch sind die neuen, erfindungsgemäßen Polymere deutlich besser für den Einsatz in Displays und Beleuchtungsanwendungen geeignet als Polymere gemäß dem Stand der Technik.

## Patentansprüche

1. Polymere enthaltend 0,01 bis 50 mol% einer oder mehrerer Struktureinheiten der Formel (I) und/oder (II) 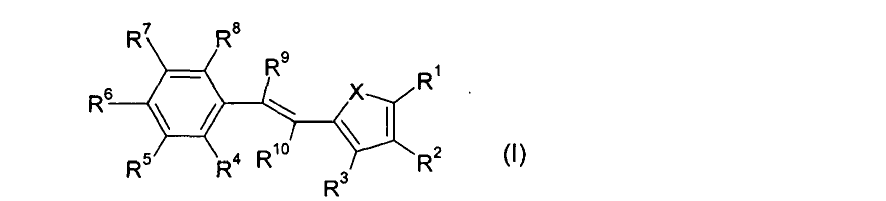 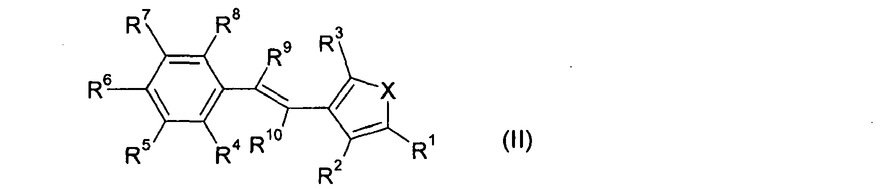 wobei die verwendeten Symbole und Indices die folgenden Bedeutungen besitzen:
R², R³, R⁴, R⁵, R⁷, R⁸, R⁹ und R¹⁰ sind unabhängig voneinander, gleich oder verschieden, H, Halogen (F, Cl, Br, I), -NO₂, -NCS, -NCO, -OCN, -SCN, -SF₅, -Si(R)₃ oder eine geradkettige, verzweigte oder cyclische Alkyl- oder Alkoxygruppe mit 1 bis 22 C-Atomen, in der auch ein oder mehrere nicht benachbarte C-Atome durch -C(R)=C(R)-, -C≡C-, -N(R)-, -O-, -S-, -CO-, -CO-O-, -O-CO- oder -O-CO-O- ersetzt sein können, wobei auch ein oder mehrere H-Atome durch Fluor ersetzt sein können,
R ist bei jedem Auftreten, gleich oder verschieden H, Halogen, eine geradkettige, verzweigte oder cyclische Alkylkette mit 1 bis 22 C-Atomen, in der auch ein oder mehrere nicht benachbarte C-Atome durch -O-, -S-, -CO-, -CO-O-, -O-CO- oder -O-CO-O- ersetzt sein können, wobei auch ein oder mehrere H-Atome durch Fluor ersetzt sein können, eine Aryl-, Aryloxy-, Heteroaryl- oder Heteroaryloxygruppe mit 5 bis 40 C-Atomen, welche auch durch ein oder mehrere nicht-aromatische Reste R², R³, R⁴, R⁵, R⁷, R⁸, R⁹ und R¹⁰ substituiert sein kann; wobei auch zwei oder mehrere Reste R miteinander und/oder mit weiteren Resten R², R³, R⁴, R⁵, R⁷, R⁸, R⁹ und R¹⁰ ein aromatisches oder aliphatisches, mono- oder polycyclisches Ringsystem bilden können, welches auch mit dem Benzolring oder dem Thiophenring in Formel (I) und/oder (II) ein kondensiertes Ringsystem bilden kann,
X ist S oder O, und
worin die beiden Reste R¹ und R⁶ die Verknüpfung im Polymer bedeuten.

2. Polymere nach Anspruch 1, **dadurch gekennzeichnet, dass** sie neben den Einheiten der Formel (I) und/oder (II) noch weitere Struktureinheiten enthalten.

3. Polymere nach Anspruch 2, **dadurch gekennzeichnet dass** die weiteren Struktureinheiten, die Lochinjektions- und/oder Lochtransporteigenschaften aufweisen, ausgewählt sind aus den Gruppen der Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weiterer O-, S- oder N-haltiger Heterocyclen mit hoch liegendem HOMO.

4. Polymere nach Anspruch 2 oder 3, **dadurch gekennzeichnet, dass** die weiteren Struktureinheiten, die Elektroneninjektions- und/oder Elektronentransporteigenschaften aufweisen, ausgewählt sind aus den Gruppen der Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weiterer O-, S- oder N-haltiger Heterocyclen mit niedrig liegendem LUMO.

5. Polymere nach einem oder mehreren der Ansprüche 2 bis 4, **dadurch gekennzeichnet, dass** die weiteren Strukturelemente die Emissionscharakteristik insoweit verändern, dass Elektrophosphoreszenz statt Elektrofluoreszenz erhalten werden kann.

6. Polymere nach einem oder mehreren der Ansprüche 2 bis 5, **dadurch gekennzeichnet, dass** die weiteren Strukturelemente, die den Übergang vom Singulett- zum Triplettzustand verbessern, ausgewählt sind aus den Klassen der Carbazol- und überbrückten Carbazoldimereinheiten, Ketone, Phosphinoxide, Sulfoxide, Sulfone und Silan-Derivate.

7. Polymere nach einem oder mehreren der Ansprüche 2 bis 6, **dadurch gekennzeichnet, dass** die weiteren Strukturelementen, die die die Emissionsfarbe der Polymere beeinflussen, ausgewählt sind aus den Klassen der 1,4-Phenylen-, 1,4-Naphthylen-, 1,4- oder 9,10-Anthrylen-, 1,6-, 2,7- oder 4,9-Pyrenylen-, 3,9- oder 3,10-Perylenylen-, 4,4'-Biphenylylen-, 4,4"-Terphenylylen-, 4,4'-Bi-1,1'-naphthylylen-, 4,4'-Tolanylen-, 4,4'-Stilbenylen-, 4,4"-Bisstyrylarylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- und Peryleriderivaten.

8. Polymere nach einem oder mehreren der Ansprüche 2 bis 7, **dadurch gekennzeichnet, dass** die weiteren Strukturelementen, die typischerweise als Backbone verwendet werden, ausgewählt sind aus den Klassen der 4,5-Dihydropyren-, 4,5,9,10-Tetrahydropyren-, Fluoren-, 9,9'-Spirobifluoren-, Phenanthren-, 9,10-Dihydrophenanthren-, 5,7-Dihydrodibenzooxepin- und cis- und trans-Indenofluorenderivate.

9. Verbindungen der Formel (III) und (IV), 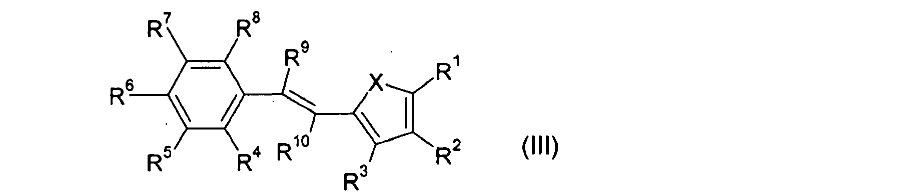 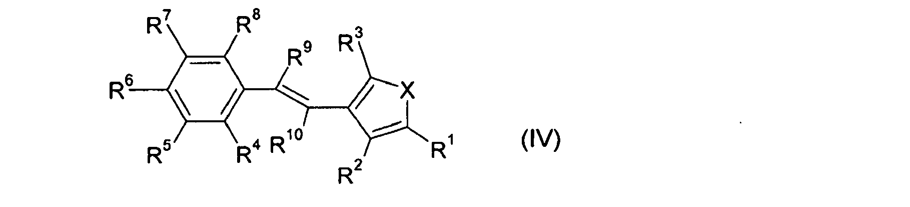 **dadurch gekennzeichnet, dass** die Reste R¹ und R⁶, gleich oder verschieden, funktionelle Gruppen sind, die unter Bedingungen der C-C- bzw. C-N-Verknüpfungen copolymerisieren,wobei die funktionellen Gruppen ausgewählt sind aus Cl, Br, I, O-Tosylat, O-Triflat, O-SO₂R¹², B(OR¹²)₂ und Sn(R¹²)₃, wobei R¹² bei jedem Auftreten gleich oder verschieden H, ein aliphatischer oder aromatischer Kohlenwasserstoffrest mit 1 bis 20 C-Atomen ist, und wobei zwei oder mehrere der Reste R¹² auch miteinander ein Ringsystem bilden können, und wobei die weiteren Symbole und Indices dieselbe Bedeutung haben, wie in Anspruch 1 in Bezug auf die Struktureinheiten (I) und (II) angegeben.

10. Mischungen (Blends) aus einem oder mehreren Polymeren nach einem oder mehreren der Ansprüche 1 bis 8 mit weiteren polymeren, oligomeren, dendritischen und/oder niedermolekularen Substanzen.

11. Lösungen und Formulierungen aus einem oder mehreren Polymeren nach einem oder mehreren der Ansprüche 1 bis 8 oder aus Blends nach Anspruch 10 in einem oder mehreren Lösungsmitteln.

12. Organische elektronische Vorrichtung mit einer oder mehreren aktiven Schichten, **dadurch gekennzeichnet, dass** mindestens eine dieser aktiven Schichten ein oder mehrere Polymere nach einem oder mehreren der Ansprüche 1 bis 8 oder Blends nach Anspruch 10 enthält.

13. Organische elektronische Vorrichtung nach Anspruch 12, **dadurch gekennzeichnet, dass** es sich um organische bzw. polymere organische Leuchtdioden (OLED, PLED), organische integrierte Schaltungen (O-IC), organische Feld-Effekt-Transistoren (OFET), organische Dünnfilmtransistoren (OTFT), organische Solarzellen (O-SC), organische Laserdioden (O-Laser), organische photo-voltaische (OPV) Elemente oder Vorrichtungen oder organische Photorezeptoren (OPCs) handelt.

## Claims

1. Polymers containing 0.01 to 50 mol% of one or more structural units of the formula (I) and/or (II) 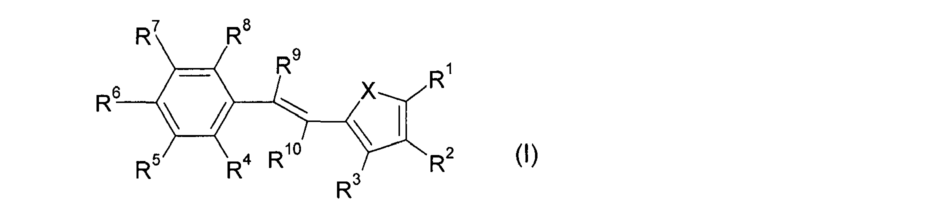 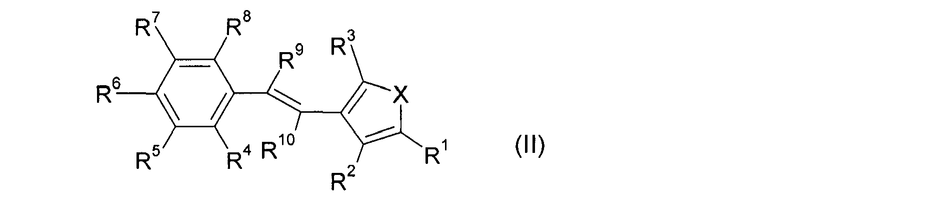 where the symbols and indices used have the following meanings:
R², R³, R⁴, R⁵, R⁷, R⁸, R⁹ and R¹⁰ are, independently of one another, identically or differently, H, halogen (F, Cl, Br, I), -NO₂, -NCS, -NCO, -OCN, -SCN, -SF₅, -Si(R)₃ or a straight-chain, branched or cyclic alkyl or alkoxy group having 1 to 22 C atoms, in which, in addition, one or more non-adjacent C atoms may be replaced by -C(R)=C(R)-, -C≡C-, -N(R)-, -O-, -S-, -CO-, -CO-O-, -O-CO- or -O-CO-O-, where, in addition, one or more H atoms may be replaced by fluorine,
R is on each occurrence, identically or differently, H, halogen, a straight-chain, branched or cyclic alkyl chain having 1 to 22 C atoms, in which, in addition, one or more non-adjacent C atoms may be replaced by -O-, -S-, -CO-, -CO-O-, -O-CO- or -O-CO-O-, where, in addition, one or more H atoms may be replaced by fluorine, an aryl, aryloxy, heteroaryl or heteroaryloxy group having 5 to 40 C atoms, which may also be substituted by one or more non-aromatic radicals R², R³, R⁴, R⁵, R⁷ , R⁸, R⁹ and R¹⁰, where, in addition, two or more radicals R may form with one another and/or with further radicals R², R³, R⁴, R⁵, R⁷, R⁸, R⁹ and R¹⁰ an aromatic or aliphatic, mono- or polycyclic ring system, which may also form a condensed ring system with the benzene ring or the thiophene ring in formula (I) and/or (II),
X is S or O, and
in which the two radicals R¹ and R⁶ denote the link in the polymer.

2. Polymers according to Claim 1, **characterised in that** they contain further structural units besides the units of the formula (I) and/or (II).

3. Polymers according to Claim 2, **characterised in that** the further structural units, which have hole-injection and/or hole-transport properties, are selected from the groups of the triarylamine, benzidine, tetraaryl-para-phenylenediamine, triarylphosphine, phenothiazine, phenoxazine, dihydrophenazine, thianthrene, dibenzo-para-dioxin, phenoxathiyne, carbazole, azulene, thiophene, pyrrole and furan derivatives and further O-, S- or N-containing heterocycles having a high HOMO.

4. Polymers according to Claim 2 or 3, **characterised in that** the further structural units, which have electron-injection and/or electron-transport properties, are selected from the groups of the pyridine, pyrimidine, pyridazine, pyrazine, oxadiazole, quinoline, quinoxaline, anthracene, benzanthracene, pyrene, perylene, benzimidazole, triazine, ketone, phosphine oxide and phenazine derivatives, but also triarylboranes and further O-, S- or N-containing heterocycles having a low LUMO.

5. Polymers according to one or more of Claims 2 to 4, **characterised in that** the further structural elements modify the emission characteristics to such an extent that electrophosphorescence can be obtained instead of electrofluorescence.

6. Polymers according to one or more of Claims 2 to 5, **characterised in that** the further structural elements, which improve the transfer from the singlet state to the triplet state, are selected from the classes of the carbazole and bridged carbazole dimer units, ketones, phosphine oxides, sulfoxides, sulfones and silane derivatives.

7. Polymers according to one or more of Claims 2 to 6, **characterised in that** the further structural elements, which influence the emission colour of the polymers, are selected from the classes of the 1,4-phenylene, 1,4-naphthylene, 1,4- or 9,10-anthrylene, 1,6-, 2,7- or 4,9-pyrenylene, 3,9- or 3,10-perylenylene, 4,4'-biphenylylene, 4,4"-terphenylylene, 4,4'-bi-1,1'-naphthylylene, 4,4'-tolanylene, 4,4'-stilbenylene, 4,4"-bisstyrylarylene, benzothiadiazole and corresponding oxygen derivatives, quinoxaline, phenothiazine, phenoxazine, dihydrophenazine, bis(thiophenyl)arylene, oligo(thiophenylene), phenazine, rubrene, pentacene and perylene derivatives.

8. Polymers according to one or more of Claims 2 to 7, **characterised in that** the further structural elements, which are typically used as backbone, are selected from the classes of the 4,5-dihydropyrene, 4,5,9,10-tetrahydropyrene, fluorene, 9,9'-spirobifluorene, phenanthrene, 9,10-dihydrophenanthrene, 5,7-dihydrodibenzoxepine and cis- and trans-indenofluorene derivatives.

9. Compounds of the formulae (III) and (IV), 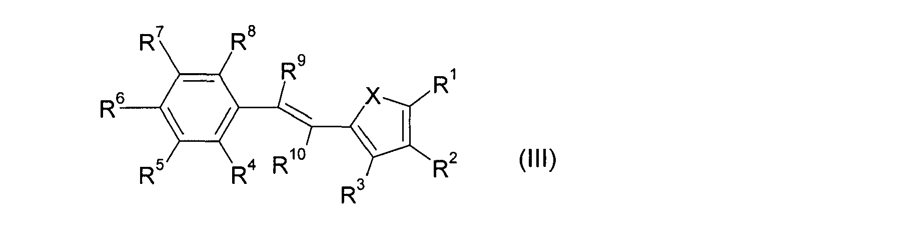 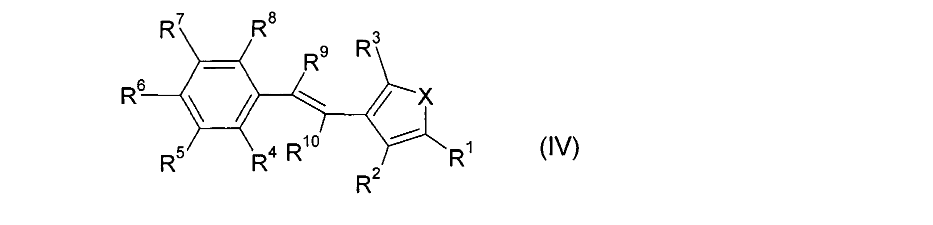 **characterised in that** the radicals R¹ and R⁶ are, identically or differently, functional groups which copolymerise under the conditions of the C-C or C-N linking reactions, where the functional groups are selected from Cl, Br, I, O-tosylate, O-triflate, O-SO₂R¹², B(OR¹²)₂ and Sn(R¹²)₃, where R¹² is on each occurrence, identically or differently, H, an aliphatic or aromatic hydrocarbon radical having 1 to 20 C atoms, and where two or more of the radicals R¹² may also form a ring system with one another, and where the other symbols and indices have the same meaning as indicated in Claim 1 in relation to the structural units (I) and (II).

10. Mixtures (blends) of one or more polymers according to one or more of Claims 1 to 8 with further polymeric, oligomeric, dendritic and/or low-molecular-weight substances.

11. Solutions and formulations comprising one or more polymers according to one or more of Claims 1 to 8 or comprising blends according to Claim 10 in one or more solvents.

12. Organic electronic device having one or more active layers, **characterised in that** at least one of these active layers comprises one or more polymers according to one or more of Claims 1 to 8 or blends according to Claim 10.

13. Organic electronic device according to Claim 12, **characterised in that** it is an organic or polymeric light-emitting diode (OLED, PLED), an organic integrated circuit (O-IC), an organic field-effect transistor (OFET), an organic thin-film transistor (OTFT), an organic solar cell (O-SC), an organic laser diode (O-laser), an organic photovoltaic (OPV) element or device or an organic photoreceptor (OPC).

## Revendications

1. Polymères contenant 0,01 à 50 mol% d'une ou de plusieurs unités structurelles de la formule (I) et/ou (II) 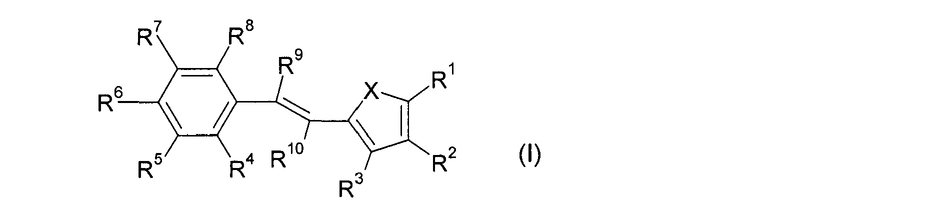 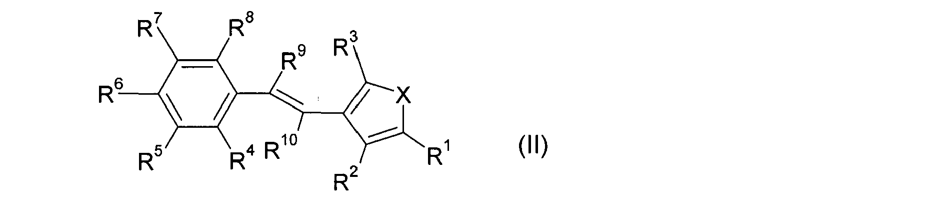 dans lesquelles les symboles et indices utilisés présentent les significations qui suivent :
R², R³, R⁴, R⁵, R⁷, R⁸, R⁹ et R¹⁰ sont, indépendamment les uns des autres, de manière identique ou différente, H, halogène (F, CI, Br, I), -NO₂, -NCS, -NCO, -OCN, -SCN, -SF₅, -Si(R)₃ ou un groupe alkyle ou alcoxy en chaîne droite, ramifié ou cyclique comportant 1 à 22 atome(s) de C, où, en outre, un ou plusieurs atome(s) de C non adjacents peut/peuvent être remplacé(s) par -C(R)=C(R)-, -C≡C-, -N(R)-, -O-, -S-, -CO-, -CO-O-, -O-CO- ou -O-CO-O-, où, en outre, un ou plusieurs atome(s) de H peut/peuvent être remplacé(s) par fluor,
R est, pour chaque occurrence, de manière identique ou différente, H, halogène, une chaîne alkyle en chaîne droite, ramifiée ou cyclique comportant 1 à 22 atome(s) de C, où, en outre, un ou plusieurs atome(s) de C non adjacents peut/peuvent être remplacé(s) par -O-, -S-, -CO-, -CO-O-, -O-CO- ou -O-CO-O-, où, en outre, un ou plusieurs atome(s) de H peut/peuvent être remplacé(s) par fluor, un groupe aryle, aryloxy, hétéroaryle ou hétéroaryloxy comportant 5 à 40 atomes de C, lequel peut également être substitué par un radical ou plusieurs radicaux non aromatique(s) R², R³, R⁴, R⁵, R⁷, R⁸, R⁹ et R¹⁰, où, en outre, deux radicaux R ou plus peuvent former l'un avec l'autre ou les uns avec les autres et/ou avec d'autres radicaux R², R³, R⁴, R⁵, R⁷, R⁸, R⁹ et R¹⁰ un système de cycle monocyclique ou polycyclique aromatique ou aliphatique,, lequel peut également former un système de cycle condensé avec le cycle benzène ou le cycle thiophène dans la formule (I) et/ou (II),
X est S ou O, et
où les deux radicaux R¹ et R⁶ représentent la liaison dans le polymère.

2. Polymères selon la revendication 1, **caractérisés en ce qu'**ils contiennent d'autres unités structurelles en plus des unités de la formule (I) et/ou (II).

3. Polymères selon la revendication 2, **caractérisés en ce que** les autres unités structurelles, lesquelles présentent des propriétés d'injection de trous et/ou de transport de trous, sont choisies parmi les groupes constitués par les dérivés de triarylamine, benzidine, tétraaryl-para-phénylènediamine, triarylphosphine, phénothiazine, phénoxazine, dihydrophénazine, thianthrène, dibenzo-para-dioxine, phénoxathiyne, carbazole, azulène, thiophène, pyrrole et furane et d'autres hétérocycles contenant O-, S- ou N présentant un HOMO élevé.

4. Polymères selon la revendication 2 ou 3, **caractérisés en ce que** les autres unités structurelles, lesquelles présentent des propriétés d'injection d'électrons et/ou de transport d'électrons, sont choisies parmi les groupes constitués par les dérivés de pyridine, pyrimidine, pyridazine, pyrazine, oxadiazole, quinoline, quinoxaline, anthracène, benzanthracène, pyrène, perylène, benzimidazole, triazine, cétone, oxyde de phosphine et phénazine, mais également les triarylboranes et d'autres hétérocycles contenant O-, S- ou N présentant un LUMO faible.

5. Polymères selon une ou plusieurs des revendications 2 à 4, **caractérisés en ce que** les autres éléments structurels modifient les caractéristiques d'émission selon un degré tel qu'une électrophosphorescence peut être obtenue en lieu et place d'une électrofluorescence.

6. Polymères selon une ou plusieurs des revendications 2 à 5, **caractérisés en ce que** les autres éléments structurels, lesquels améliorent le transfert depuis l'état singlet jusqu'à l'état triplet, sont choisis parmi les classes des unités de dimère carbazole et carbazole ponté, les cétones, les oxydes de phosphine, les sulfoxydes, les sulfones et les dérivés de silane.

7. Polymères selon une ou plusieurs des revendications 2 à 6, **caractérisés en ce que** les autres éléments structurels, lesquels influencent la couleur d'émission des polymères, sont choisis parmi les classes des 1,4-phénylène, 1,4-naphtylène, 1,4- ou 9,10-anthrylène, 1,6-, 2,7- ou 4,9-pyrénylène, 3,9- ou 3,10-perylènylène, 4,4'-biphénylylène, 4,4"-terphénylylène, 4,4'-bi-1,1'-naphtylylène, 4,4'-tolanylène, 4,4'-stilbenylène, 4,4"-bisstyrylarylène, benzothiadiazole et des dérives d'oxygène correspondants, des dérivés de quinoxaline, phénothiazine, phénoxazine, dihydrophénazine, bis(thiophényl)arylène, oligo(thiophénylène), phénazine, rubrène, pentacène et perylène.

8. Polymères selon une ou plusieurs des revendications 2 à 7, **caractérisés en ce que** les autres éléments structurels, lesquels sont typiquement utilisés en tant qu'ossature, sont choisis parmi les classes des dérivés de 4,5-dihydropyrène, 4,5,9,10-tétrahydropyrène, fluorène, 9,9'-spirobifluorène, phénanthrène, 9,10-dihydrophénanthrène, 5,7-dihydrodibenzoxepine et cis- et trans-indénofluorène.

9. Composés des formules (III) et (IV) : 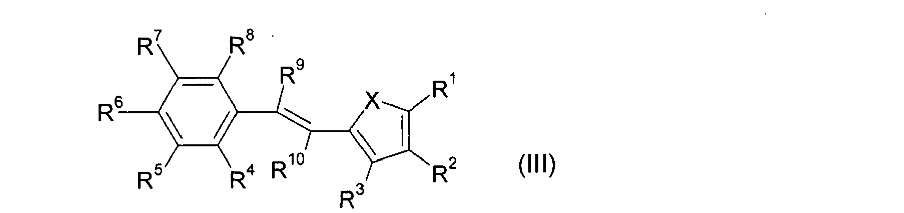 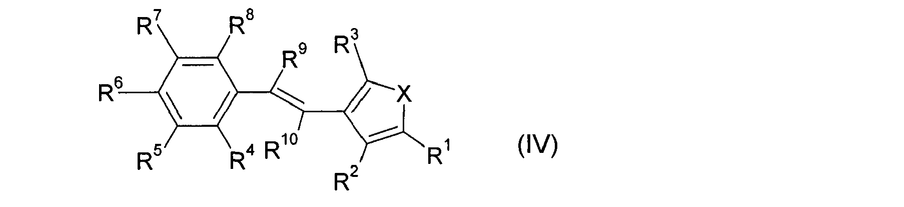 **caractérisés en ce que** les radicaux R¹ et R⁶ sont, de manière identique ou différente, des groupes fonctionnels qui se copolymérisent sous les conditions des réactions de liaison C-C ou C-N, où les groupes fonctionnels sont choisis parmi Cl, Br, I, O-tosylate, O-triflate, O-SO₂R¹², B(OR¹²)₂ et Sn(R¹²)₃, où R¹² est, pour chaque occurrence, de manière identique ou différente, H, un radical hydrocarbone aliphatique ou aromatique comportant 1 à 20 atome(s) de C, et où deux des radicaux R¹² ou plus peuvent également former un système de cycle l'un avec l'autre ou les uns avec les autres, et où les autres symboles et indices présentent la même signification qu'indiquée selon la revendication 1 en relation avec les unités structurelles (I) et (II).

10. Mixtures (mélanges) d'un ou de plusieurs polymère(s) selon une ou plusieurs des revendications 1 à 8 avec d'autres substances polymériques, oligomériques, dendritiques et/ou de poids moléculaire faible.

11. Solutions et formulations comprenant un ou plusieurs polymère(s) selon une ou plusieurs des revendications 1 à 8 ou comprenant des mélanges selon la revendication 10 dans un ou plusieurs solvant(s).

12. Dispositif électronique organique comportant une ou plusieurs couche(s) active(s), **caractérisé en ce qu'**au moins l'une de ces couches actives comprend un ou plusieurs polymère(s) selon une ou plusieurs des revendications 1 à 8 ou des mélanges selon la revendication 10.

13. Dispositif électronique organique selon la revendication 12, **caractérisé en ce qu'**il s'agit d'une diode émettrice de lumière organique ou polymérique (OLED, PLED), d'un circuit intégré organique (O-IC), d'un transistor à effet de champ organique (OFET), d'un transistor à film mince organique (OTFT), d'une cellule solaire organique (O-SC), d'une diode laser organique (O-laser), d'un élément ou dispositif photovoltaïque organique (OPV) ou d'un photorécepteur organique (OPC).
